(19) Europäisches Patentamt
European Patent Office
Office européen des brevets

(11) **EP 3 769 098 B1**

(12) **FASCICULE DE BREVET EUROPEEN**

(45) Date de publication et mention de la délivrance du brevet:
**06.04.2022 Bulletin 2022/14**

(21) Numéro de dépôt: **19707791.0**

(22) Date de dépôt: **27.02.2019**

(51) Classification Internationale des Brevets (IPC):
**G01R 31/34** (2020.01)    **G01R 27/02** (2006.01)

(52) Classification Coopérative des Brevets (CPC):
**G01R 31/343; G01R 27/025;** Y02T 10/70;
Y02T 10/7072; Y02T 10/72; Y02T 90/14

(86) Numéro de dépôt international:
**PCT/EP2019/054866**

(87) Numéro de publication internationale:
**WO 2019/179736 (26.09.2019 Gazette 2019/39)**

(54) **PROCEDE DE DETERMINATION D'AU MOINS DEUX RESISTANCES EQUIVALENTES D'ISOLEMENT D'UN SYSTEME ELECTRIQUE**

VERFAHREN ZUR BESTIMMUNG VON MINDESTENS ZWEI ÄQUIVALENTEN ISOLATIONSWIDERSTÄNDEN EINES ELEKTRISCHEN SYSTEMS

METHOD FOR DETERMINING AT LEAST TWO EQUIVALENT INSULATION RESISTANCES OF AN ELECTRICAL SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.03.2018 FR 1852530**

(43) Date de publication de la demande:
**27.01.2021 Bulletin 2021/04**

(73) Titulaire: **IFP Energies nouvelles
92852 Rueil-Malmaison (FR)**

(72) Inventeurs:
• **HAJE OBEID, Najla
92852 RUEIL-MALMAISON CEDEX (FR)**
• **BATTISTON, Alexandre
92852 RUEIL-MALMAISON CEDEX (FR)**

(74) Mandataire: **IFP Energies nouvelles
Département Propriété Industrielle
Rond Point de l'échangeur de Solaize
BP3
69360 Solaize (FR)**

(56) Documents cités:
JP-A- 2012 233 826     US-A1- 2008 150 549
US-A1- 2011 320 146

EP 3 769 098 B1

**Description**

La présente invention concerne le domaine de la surveillance d'un système électrique. L'invention concerne en particulier la détermination de résistance d'isolement d'un système électrique.

Dans les pratiques de fabrication modernes, les systèmes de surveillance intégrés sont devenus indispensables, afin d'assurer la sécurité des utilisateurs et du matériel.

Par exemple, dans le domaine des groupes moto propulseurs électriques (GMP électrique), pour assurer la sureté de fonctionnement d'un système onduleur - machine électrique et pour assurer la sécurité des utilisateurs, il faut effectuer régulièrement des mesures de la résistance d'isolement du côté de la batterie (généralement haute tension) ainsi que du côté de la machine électrique, et notamment de ses enroulements (bobines). Ces mesures ont pour objectif de limiter les risques électriques, notamment les risques de court-circuit ou d'électrocution. il existe donc un fort intérêt de développer des moyens de surveillance intégrés au système.

D'un point de vue machine électrique, il est nécessaire de mesurer la résistance d'isolement dans tout système non isolé (par exemple galvaniquement) dont la tension de source est supérieure à 48V. Cette mesure permet de détecter les défauts d'isolement phase-Terre (ou phase-châssis) et joue ainsi un rôle important dans la protection des personnes.

La surveillance de la résistance d'isolement doit également être effectuée entre les connecteurs de puissance côté batterie (bornes positive et négative) et la Terre/châssis.

Les dispositifs de mesure des résistances d'isolement du côté de la batterie (généralement haute tension (supérieure à 120 Vdc)) ainsi que du côté de la machine (notamment de ses enroulements) actuellement présents sur le marché industriel sont des dispositifs indépendants au système de pilotage de la machine. Ils sont connus sous le nom de contrôleur permanent d'isolement (CPI). Ces systèmes ne sont pas intégrés dans le système électrique, ils nécessitent donc l'arrêt du système électrique (pour l'installation du CPI et la réalisation des mesures).

En outre, différentes méthodes et systèmes de mesure de résistances d'isolement ont été développés.

Par exemple, la demande de brevet EP 2413148 concerne un circuit de mesure de la résistance d'isolement non influencé par la tension de batterie. Ce circuit de mesure est adapté uniquement à déterminer la résistance d'isolement d'une batterie, mais ne permet pas de déterminer une résistance d'isolement pour un système électrique complet (comprenant une batterie, un onduleur, et une charge électrique), et par conséquent ce circuit de mesure ne permet pas de localiser un éventuel défaut d'isolement d'un système électrique. Les méthodes de mesure présentées dans les demandes de brevet US 20030234653 et US 2015042350 présentent les mêmes limitations.

Le brevet US 7554336 divulgue une méthode pour mesurer la résistance d'isolement d'un circuit électrique. Pour ce procédé, une des mesures se fait en « OFFLINE » (hors ligne), état qui est décrit comme étant celui où tous les interrupteurs de l'onduleur sont ouverts. Cela n'est pas un cas commun d'une commande onduleur, et nécessite de modifier le pilotage de l'onduleur. Donc il faut avoir accès au pilotage de l'onduleur pour insérer ces états. De plus, ce circuit est complexe et est limité aux réseaux informatiques (IT).

La demande de brevet US 2012223734 décrit quant à elle une méthode de mesure de résistance d'isolement appliquée à des panneaux photovoltaïques. Cette méthode utilise un instrument spécifique pour réaliser la mesure de la résistance d'isolement. Ainsi, ce document ne décrit pas un moyen de mesure pouvant être embarqué, ce qui est utile notamment pour les applications GMP électrique.

La demande de brevet WO 2013124571 décrit un procédé et un système d'estimation de la résistance d'isolement entre une batterie et une masse électrique. Ce procédé nécessite l'application d'une tension pour réaliser les mesures, ce qui est contraignant et qui limite l'utilisation de la batterie pendant la mesure.

La demande de brevet US 2011/0320146 décrit un dispositif pour détecter une dégradation de l'isolement.

Pour pallier ces inconvénients, la présente invention concerne un procédé de détermination d'au moins deux résistances équivalentes d'isolement pour un système électrique intégrant une source électrique (par exemple une batterie), un onduleur, une charge électrique (par exemple une machine électrique), et un circuit de mesure. Les mesures sont réalisées en fonctionnement du système électrique, lorsque les interrupteurs commandés de l'onduleur sont dans une séquence nulle, ce qui permet de mettre en œuvre le procédé lors du fonctionnement du système électrique. Un tel procédé est adapté pour déterminer la résistance d'isolement d'un système électrique, et permet la localisation d'un éventuel défaut d'isolement au sein du système électrique.

La présente invention concerne également un système de commande mettant en œuvre un tel procédé.

**Le procédé et le système selon l'invention**

L'invention est exposée dans le jeu de revendications joint.

L'invention concerne un procédé de détermination d'au moins deux résistances équivalentes d'isolement d'un système électrique intégrant une source électrique, un convertisseur d'énergie, et une charge électrique, ledit convertisseur d'énergie comprenant une pluralité de branches de commutation, chacune desdites branches de commutation comprenant deux interrupteurs commandés, ledit système électrique intégrant en outre un circuit de mesure ajouté entre la borne positive de ladite source électrique et la terre ou le châssis dudit système électrique, ledit circuit de mesure comprenant une résistance de shunt (Rshunt) en série avec un interrupteur commandé. Pour ce procédé, on met en œuvre les étapes suivantes :

a) lorsque les interrupteurs commandés dudit convertisseur d'énergie sont en séquence nulle, on mesure deux tensions en parallèle dudit circuit de mesure, la première tension $V_{pt\_0}$ étant mesurée avec ledit interrupteur commandé dudit circuit de mesure en position ouverte, et la deuxième tension $V_{pt\_1}$ étant mesurée avec ledit interrupteur commandé dudit circuit de mesure en position fermée ; et

b) on détermine lesdites résistances équivalentes d'isolement dudit système électrique au moyen desdites tensions mesurées $V_{pt\_0}$ et $V_{pt\_1}$.

Selon un mode de réalisation de l'invention, on commande lesdits interrupteurs commandés dudit convertisseur d'énergie par une méthode de modulation de largeur d'impulsion.

Conformément à une mise en œuvre, on détermine quatre résistances équivalentes d'isolement, en réitérant les étapes a) et b) pour chaque séquence nulle de la commande des interrupteurs commandés dudit convertisseur d'énergie.

Avantageusement, on détermine une résistance équivalente d'isolement $R_{\_iso\_h}+$ entre la borne positive de ladite source électrique et le châssis ou la terre dudit système électrique pour la séquence nulle pour laquelle les interrupteurs commandés dudit convertisseur d'énergie connectés à la borne positive de ladite source électrique sont

$$R_{\_iso\_h}+ = R_{\_shunt} \left[ \frac{V_{pt\_h0}}{V_{batt}-V_{pt\_h0}} \frac{V_{batt}-V_{pt\_h1}}{V_{pt\_h1}} - 1 \right]$$

en position fermée par une équation du type : avec $R_{\_shunt}$ la résistance de shunt, $V_{batt}$ la tension de ladite source électrique, $V_{pt\_h0}$ la première tension mesurée pour cette séquence nulle et $V_{pt\_h1}$ la deuxième tension mesurée pour cette séquence nulle.

De manière avantageuse, on détermine une résistance équivalente d'isolement $R_{\_iso\_\_\_h}-$ entre la borne négative de ladite source électrique et le châssis ou la terre dudit système électrique pour la séquence nulle pour laquelle les interrupteurs commandés dudit convertisseur d'énergie connectés à la borne positive de ladite source électrique

$$R_{\_iso\_h}- = \frac{R_{\_iso\_h}+ \times R_{\_shunt}}{R_{\_iso\_h}+ + R_{\_shunt}} \left( \frac{V_{batt}}{V_{pt\_h1}} - 1 \right)$$

sont en position fermée par une équation du type : avec $R_{\_shunt}$ la résistance de shunt, $V_{batt}$ la tension de ladite source électrique, et $V_{pt\_h1}$ la deuxième tension mesurée pour cette séquence nulle.

Selon un aspect, on détermine une résistance équivalente d'isolement $R_{\_iso\_b}+$ entre la borne positive de ladite source électrique et le châssis ou la terre dudit système électrique pour la séquence nulle pour laquelle les interrupteurs commandés dudit convertisseur d'énergie connectés à la borne négative de ladite source électrique sont en position

$$R_{\_iso\_b}+ = R_{\_shunt} \left[ \frac{V_{pt\_b0}}{V_{batt}-V_{pt\_b0}} \frac{V_{batt}-V_{pt\_b1}}{V_{pt\_b1}} - 1 \right]$$

fermée par une équation du type : avec $R_{\_shunt}$ la résistance de shunt, $V_{batt}$ la tension de ladite source électrique, $V_{pt\_b0}$ la première tension mesurée pour cette séquence nulle et $V_{pt\_b1}$ la deuxième tension mesurée pour cette séquence nulle.

De préférence, on détermine une résistance équivalente d'isolement $R_{\_iso\_b}-$ entre la borne négative de ladite source électrique et le châssis ou la terre dudit système électrique pour la séquence nulle pour laquelle les interrupteurs commandés dudit onduleur connectés à la borne négative de ladite source électrique sont en position fermée par une

$$R_{\_iso\_b}- = \frac{R_{\_iso\_b}+ \times R_{\_shunt}}{R_{\_iso\_b}+ + R_{\_shunt}} \left( \frac{V_{batt}}{V_{pt\_b1}} - 1 \right)$$

équation du type : avec $R_{\_shunt}$ la résistance de shunt, $V_{batt}$ la tension de ladite source électrique, et $V_{pt\_b1}$ la deuxième tension mesurée pour cette séquence nulle.

Conformément à un mode de réalisation, on compare lesdites résistances équivalentes d'isolement à un seuil pour déterminer un éventuel défaut d'isolement dudit système électrique.

Avantageusement, on localise le défaut éventuel d'isolement en mettant en œuvre les conditions suivantes :

i) si toutes les résistances équivalentes sont supérieures audit seuil, alors il n'y a pas de défaut d'isolement dudit système électrique,

ii) si seulement les résistances équivalentes $R_{\_iso\_h}+$ et $R_{\_iso\_b}-$ sont inférieures audit seuil, alors le défaut d'isolement est situé du côté de ladite charge électrique,

iii) si seulement les résistances équivalentes $R_{iso\_h}+$ et $R_{iso\_b}+$ sont inférieures audit seuil, alors le défaut d'isolement est situé du côté de la borne positive de ladite source électrique,

iv) si seulement les résistances équivalentes $R_{iso\_h}-$ et $R_{iso\_b}-$ sont inférieures audit seuil, alors le défaut d'isolement est situé du côté de la borne négative de ladite source électrique,

v) si seulement les résistances équivalentes $R_{iso\_h}+$, $R_{iso\_b}+$ et $R_{iso\_b}-$ sont inférieures audit seuil, alors des défauts d'isolement sont situés du côté de la borne positive de ladite source électrique et du côté de ladite charge électrique,

vi) si seulement les résistances équivalentes $R_{iso\_h}+$, $R_{iso\_h}-$ et $R_{iso\_b}-$ sont inférieures audit seuil, alors des défauts d'isolement sont situés du côté de la borne négative de ladite source électrique et du côté de ladite charge électrique, et

vii) si toutes les résistances équivalentes sont inférieures audit seuil, alors des défauts d'isolement sont situés du côté des bornes positives et négatives de ladite source électrique.

Selon un aspect, ledit seuil S est déterminé par une formule du type $S = a \times V_{batt}$ avec $a$ un coefficient de sécurité et $V_{batt}$ la tension de ladite source électrique, de préférence le coefficient de sécurité $a$ vaut 1000 $\Omega/V$.

De plus, l'invention concerne un système de commande d'un système électrique pour la détermination d'au moins deux résistances équivalentes d'isolement dudit système électrique, ledit système électrique intégrant une source électrique, un convertisseur d'énergie, une charge électrique et un circuit de mesure, ledit onduleur comprenant une pluralité de branches de commutation, chacune desdites branches de commutation comprenant deux interrupteurs commandés, ledit circuit de mesure comprenant une résistance de shunt en série avec un interrupteur commandé ajoutés entre la borne positive de ladite source électrique et la terre ou le châssis dudit système électrique. Ledit système de commande est configuré pour mettre en œuvre le procédé selon l'une des caractéristiques précédentes.

Selon un mode de réalisation, ladite charge électrique est une machine électrique, et ladite source électrique est une batterie électrique.

En outre, l'invention concerne une utilisation d'un système de commande selon l'une des caractéristiques précédentes pour la commande d'un groupe motopropulseur d'un véhicule électrique ou hybride.

## Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre un système électrique équipé d'un circuit de mesure adapté pour mettre en œuvre le procédé selon un mode de réalisation de l'invention.

La figure 2 illustre les instants d'acquisition des tensions selon un mode de réalisation de l'invention.

## Description détaillée de l'invention

La présente invention concerne un procédé de détermination d'au moins deux résistances équivalentes d'isolement d'un système électrique.

On appelle résistance d'isolement la résistance électrique des moyens d'isolement entre un système électrique et son milieu extérieur (généralement de l'air entre le système électrique et son boîtier). Cette résistance d'isolement représente la résistance formée entre le système électrique et la terre (cas d'un système électrique stationnaire), ou entre le système électrique et son châssis (cas d'un système électrique embarqué du type véhicule électrique). La connaissance de cette valeur permet de déterminer un défaut d'isolement d'un système électrique. Un tel défaut d'isolement peut générer des problèmes de sureté d'un système électrique.

La résistance d'isolement est dite équivalente car elle dépend de la constitution du circuit de mesure, en particulier de la résistance de shunt (le circuit de mesure est décrit dans la suite de la description).

Le système électrique selon l'invention intègre une source électrique, un convertisseur d'énergie et une charge électrique.

La source électrique permet de fournir de l'énergie électrique, il peut s'agir d'une batterie électrique fournissant une énergie électrique continue.

Le convertisseur d'énergie permet une conversion de l'énergie électrique. Par exemple, un convertisseur d'énergie peut permettre de convertir une tension alternative en une autre tension alternative avec une fréquence et/ou une amplitude différente, on parle alors de convertisseur alternatif/alternatif ou AC/AC. Selon un autre exemple, un convertisseur d'énergie peut permettre de convertir une tension alternative en une tension continue, on parle alors de redresseur, convertisseur alternatif/continu ou AC/DC. Pour la conversion inverse continu/alternatif, on parle d'onduleur ou convertisseur DC/AC. Selon un dernier exemple, un convertisseur d'énergie peut convertir une tension continue en une tension continue de tension différente, on parle alors de convertisseur DC/DC. Les convertisseurs peuvent être réversibles ou non réversibles. Généralement, la conversion est mise en œuvre au moyen de commutateurs (interrupteurs) commandés répartis sur plusieurs (généralement un nombre multiple de trois) branches de commutation. Chaque branche de commutation comporte deux interrupteurs commandés de manière opposée : lorsque le premier interrupteur commandé est ouvert, le second interrupteur commandé de la même branche est fermé et inversement.

La charge électrique désigne tout système utilisant de l'énergie électrique. La charge électrique peut être une machine électrique, une charge résistive, un réseau électrique, etc....

Selon un mode de réalisation préféré de l'invention, le système électrique comprend une batterie, un onduleur DC/AC à trois branches, et une machine électrique triphasée.

En outre, le système électrique intègre un circuit de mesure. En d'autres termes le circuit de mesure est inclus dans le système électrique. Le circuit de mesure est utilisé et piloté pour déterminer les résistances équivalentes d'isolement. Ainsi, la détermination des résistances d'isolement peut être mise en œuvre sans équipement spécifique (par exemple capteur) extérieur au système électrique.

Le circuit de mesure est ajouté entre la borne positive de la source électrique et la terre ou le châssis du système électrique.

Le circuit de mesure comporte une résistance de shunt en série avec un interrupteur commandé. La résistance de shunt peut avoir une valeur comprise entre 500kΩ et 5MΩ.

Selon un aspect de l'invention, tous les interrupteurs commandés (c'est-à-dire ceux du convertisseur d'énergie et celui du circuit de mesure) peuvent être des commutateurs de type MOSFET (acronyme anglais de « Metal Oxide Semiconductor Field Effect Transistor » qui se traduit par transistor à effet de champ à structure métal-oxyde-semiconducteur) et/ou IGBT (transistor bipolaire à grille isolée de l'anglais « Insulated Gate Bipolar Transistor »), et/ou toute autre technologie analogue.

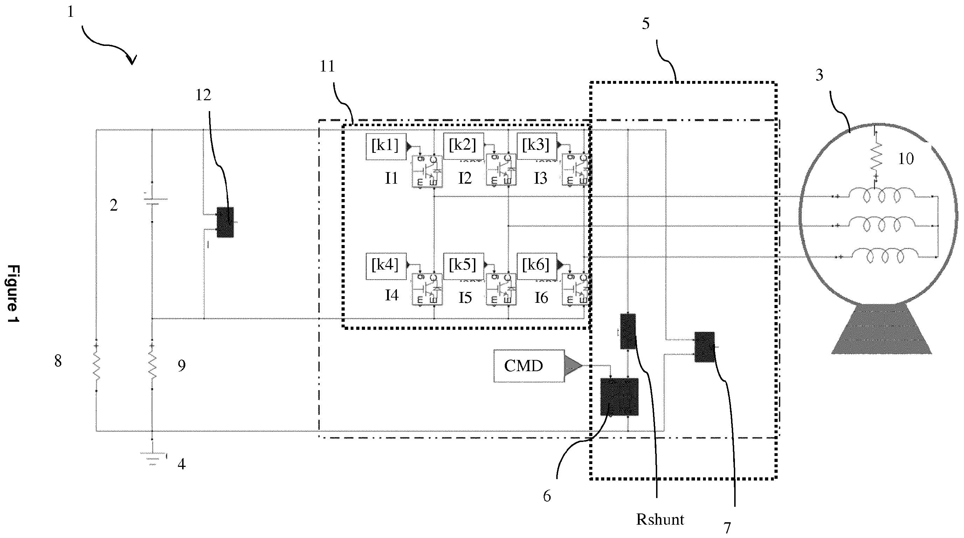

La figure 1 illustre, schématiquement et de manière non limitative, un système électrique adapté au procédé selon un mode de réalisation de l'invention. Le circuit électrique 1 intègre une source électrique 2 (en l'occurrence une batterie électrique), un onduleur 11 (qui est un convertisseur d'énergie), une charge électrique 3 (en l'occurrence une machine électrique triphasée), et un circuit de mesure 5.

L'onduleur 11 comprend trois bras de commutation, chaque bras de commutation comprenant deux interrupteurs commandés I1 à I6 en série. Chacun des interrupteurs commandés, comporte une commande [k1] à [k6]. La première branche de l'onduleur 11 comporte les interrupteurs I1 et I4, la commande [k4] de l'interrupteur I4 étant opposée à la commande [k1] de l'interrupteur I1 (I4 est ouvert quand I1 est fermé et inversement). La deuxième branche de l'onduleur 11 comporte les interrupteurs I2 et I5, la commande [k5] de l'interrupteur I5 étant opposée à la commande [k2] de l'interrupteur I2. La troisième branche de l'onduleur 11 comporte les interrupteurs I3 et I6, la commande [k6] de l'interrupteur I6 étant opposée à la commande [k3] de l'interrupteur I3.

Le circuit de mesure 5 est agencé entre la borne positive de la source électrique 2 et la terre ou le châssis 4 du système électrique 2. Le circuit de mesure 5 comporte une association en série d'une résistance de shunt Rshunt avec un interrupteur commandé 6. La commande CMD de l'interrupteur commandé 6 permet l'ouverture et la fermeture de l'interrupteur commandé 6. Le circuit de mesure 5 comporte en outre des moyens de mesure de la tension 7 aux bornes du circuit de mesure 5.

De plus, sur la figure 1 sont représentées les résistances d'isolement 8, 9 et 10. La résistance d'isolement 8 est située entre la borne positive de la source électrique 2 et la terre ou le châssis 4 du système électrique. La résistance d'isolement 9 est située entre la borne négative de la source électrique 2 et la terre ou le châssis 4 du système électrique 1. La résistance d'isolement 10 est située entre la charge électrique 3 et la terre ou le châssis 4 du système électrique.

La figure 1 illustre en outre des moyens de mesure 12 de la tension de la source électrique 2.

Le procédé selon l'invention comporte les étapes suivantes :

    a) lorsque les interrupteurs commandés de l'onduleur sont en séquence nulle, on mesure deux tensions, les tensions étant mesurées en parallèle du circuit de mesure, la première tension étant mesurée en ouvrant l'interrupteur commandé du circuit de mesure, et la deuxième tension étant mesurée en fermant l'interrupteur commandé du circuit de mesure, et

    b) on détermine les résistances équivalentes d'isolement du système électrique au moyen des tensions mesurées.

La séquence nulle de commande de l'onduleur correspond aux instants de la commande de l'onduleur pendant lesquels aucun courant différentiel ne transite entre la source électrique et la charge électrique. La puissance prélevée sur la source électrique est donc nulle pendant ces séquences. Une première séquence nulle est obtenue lorsque les interrupteurs commandés de l'onduleur connectés à la borne positive de la source électrique sont tous fermés. Une deuxième séquence nulle est obtenue lorsque les interrupteurs commandés de l'onduleur connectés à la borne négative de la source électrique sont tous fermés.

Pour l'exemple de la figure 1, la première séquence nulle correspond à la fermeture des interrupteurs commandés I1, I2 et I3 (I4, I5 et I6 étant ouverts), et la deuxième séquence nulle correspond à la fermeture des interrupteurs commandés I4, I5 et I6 (I1, I2 et I3 étant ouverts).

Le procédé selon l'invention ne vient pas modifier la commande des interrupteurs commandés de l'onduleur, il utilise des séquences spécifiques existantes de la commande de l'onduleur pour réaliser les mesures. Le procédé selon l'invention commande uniquement l'interrupteur commandé du circuit de mesure, dans le but de réaliser deux mesures de tension. Ainsi, il est possible d'utiliser le procédé selon l'invention en fonctionnement du système électrique (pas besoin d'arrêter le système électrique pour réaliser la détermination des résistances d'isolement).

De plus, le procédé selon l'invention ne nécessite pas de modification de l'onduleur.

En outre, l'invention permet une détermination de résistances d'isolement de manière ponctuelle, en ligne et en temps réel.

De préférence, les interrupteurs commandés de l'onduleur sont commandés par une méthode de modulation de largeur d'impulsion (MLI ou en anglais PWM pour « Pulse Width Modulation »). Le principe général de cette méthode de modulation est qu'en appliquant une succession d'états discrets pendant des durées bien choisies, on peut obtenir en moyenne sur une certaine durée n'importe quelle valeur intermédiaire.

Selon un mode de réalisation de l'invention, on réalise la détermination de résistances équivalentes d'isolement pour chaque séquence nulle de la commande des interrupteurs commandés de l'onduleur. Pour cela, on réitère les étapes a) et b) décrites ci-dessus pour les deux séquences nulles. Ainsi, on a deux mesures de tensions pour la première séquence nulle, et deux mesures de tensions pour la deuxième séquence nulle. Ces quatre tensions permettent de déterminer quatre résistances équivalentes d'isolement. Ce qui permet une localisation précise d'un défaut d'isolement du circuit électrique.

Dans le but de réaliser les mesures au moment d'une séquence nulle de la commande de l'onduleur, le procédé selon l'invention peut comprendre une étape de détection des séquences nulles.

Par exemple, cette détection peut être mise en œuvre par mesure d'un courant dans le système électrique, ou de manière prédictive en connaissant les états futurs de la commandes des interrupteurs commandés de l'onduleur.

Selon un aspect de l'invention, le procédé peut comprendre une étape de mesure de la tension aux bornes de la source électrique. Cette tension de la source électrique peut être utilisée pour l'étape b) de détermination des résistances équivalentes d'isolement.

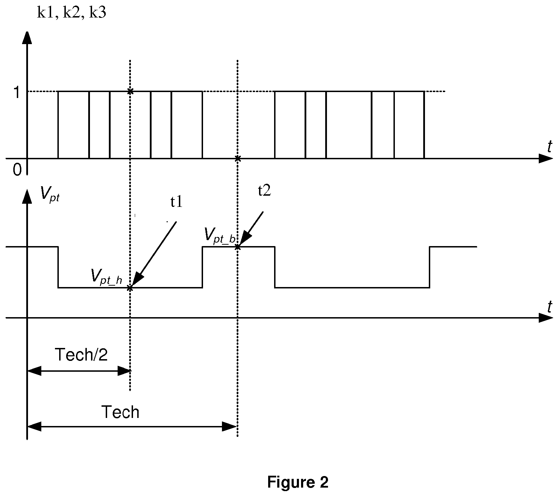

La figure 2 illustre les instants de mesure du procédé selon un mode de réalisation de l'invention, pour l'exemple de système électrique illustré en figure 1. Le graphe du haut représente schématiquement et de manière non limitative, la commande k1, k2, et k3 pour une méthode de modulation de largeur d'impulsion (les courbes des commandes k1, k2, et k3 sont illustrées dans le même référentiel). La valeur 1 de ces commandes correspond à la fermeture des interrupteurs commandés correspondant, et la valeur 0 de ces commandes correspond à l'ouverture des interrupteurs commandés correspondant. Le graphe du bas représente schématiquement et de manière non limitative, la tension de mesure aux bornes du circuit de mesure. A l'instant t1, on a une première séquence nulle (k1=k2=k3=1), on peut donc réaliser deux premières mesures de tension notées $V_{pt\_h0}$ (pour le cas où l'interrupteur commandé du circuit de mesure est ouvert) et $V_{pt\_h1}$ (pour le cas où l'interrupteur commandé du circuit de mesure est fermé). A l'instant t2, on a une deuxième séquence nulle (k1=k2=k3=0 donc K4=k5=k6=1), on peut donc réaliser deux autres mesures de tension notées $V_{pu\_b0}$ (pour le cas où l'interrupteur commandé du circuit de mesure est ouvert) et $V_{pt\_b1}$ (pour le cas où l'interrupteur commandé du circuit de mesure est fermé).

De plus, on illustre sur la figure 2, que pour déterminer les résistances équivalentes d'isolement, on peut faire l'acquisition de la tension aux bornes du circuit de mesure à deux instants espacés de Tech/2 (Tech représente la période d'échantillonnage de la méthode de modulation de largeur d'impulsion).

L'étape b) de détermination des résistances équivalentes d'isolement peut être mis en œuvre par application des lois classiques en électricité, notamment la loi d'Ohm, la loi des mailles et la loi des nœuds.

Selon un aspect de l'invention, l'étape b) de détermination des résistances équivalentes peut être mise en œuvre par le calculateur du convertisseur d'énergie (par exemple de l'onduleur). Alternativement, cette étape peut être mise en œuvre par un calculateur dédié.

Selon un premier mode de réalisation, on peut déterminer deux résistances équivalentes d'isolement $R_{\_iso\_h}+$ et $R_{\_iso\_h}$- pour la séquence nulle pour laquelle les interrupteurs commandés de l'onduleur connectés à la borne positive de la source électrique sont en position fermée (dans le cas des figures 1 et 2, cela correspond à k1=k2=k3=1).

Pour ce mode de réalisation, on peut déterminer une résistance équivalente d'isolement $R_{\_iso\_h}+$ entre la borne positive de la source électrique et le châssis ou la terre du système électrique pour la séquence nulle pour laquelle les interrupteurs commandés de l'onduleur connectés à la borne positive de la source électrique sont en position fermée par une équation du type :
$$R_{\_iso\_h}+ = R_{\_shunt}\left[\frac{V_{pt\_h0}}{V_{batt}-V_{pt\_h0}}\frac{V_{batt}-V_{pt\_h1}}{V_{pt\_h1}} - 1\right]$$
avec $R_{\_shunt}$ la résistance de shunt, $V_{batt}$ la tension de ladite source électrique, $V_{pt\_h0}$ la première tension mesurée pour cette séquence nulle et $V_{pt\_h1}$ la deuxième tension mesurée pour cette séquence nulle.

De plus, on peut déterminer une résistance équivalente $R_{\_iso\_h}$- entre la borne négative de la source électrique et le châssis ou la terre du système électrique pour la séquence nulle pour laquelle les interrupteurs commandés de l'onduleur connectés à la borne positive de la source électrique sont en position fermée par une équation du type :

$$R_{\_iso\_h}- = \frac{R_{\_iso\_h}+ \times R_{\_shunt}}{R_{\_iso\_h}+ + R_{\_shunt}}\left(\frac{V_{batt}}{V_{pt\_h1}} - 1\right)$$ avec $R_{\_shunt}$ la résistance de shunt, $V_{batt}$ la tension de ladite source électrique, et $V_{pt\_h1}$ la deuxième tension mesurée pour cette séquence nulle.

Selon un deuxième mode de réalisation, on peut déterminer deux résistances équivalentes d'isolement $R_{\_iso\_b}+$ et $R_{\_iso\_b}-$ pour la séquence nulle pour laquelle les interrupteurs commandés de l'onduleur connectés à la borne négative de la source électrique sont en position fermée (dans le cas des figures 1 et 2, cela correspond à k4=k5=k6=1, donc avec k1=k2=k3=0).

Pour ce mode de réalisation, on peut déterminer une résistance équivalente $R_{\_iso\_b}+$ entre la borne positive de la source électrique et le châssis ou la terre du système électrique pour la séquence nulle pour laquelle les interrupteurs commandés de l'onduleur connectés à la borne négative de ladite source électrique sont en position fermée par une équation du type :

$$R_{\_iso\_b}+ = R_{\_shunt}\left[\frac{V_{pt\_b0}}{V_{batt}-V_{pt\_b0}}\frac{V_{batt}-V_{pt\_b1}}{V_{pt\_b1}} - 1\right]$$ avec $R_{\_shunt}$ la résistance de shunt, $V_{batt}$ la tension de ladite source électrique, $V_{pt\_b0}$ la première tension mesurée pour cette séquence nulle et $V_{pt\_b1}$ la deuxième tension mesurée pour cette séquence nulle.

En outre, on peut déterminer une résistance équivalente $R_{\_iso\_b}-$ entre la borne négative de ladite source électrique et le châssis ou la terre dudit système électrique pour la séquence nulle pour laquelle les interrupteurs commandés de l'onduleur connectés à la borne négative de ladite source électrique sont en position fermée par une équation du type :

$$R_{\_iso\_b}- = \frac{R_{\_iso\_b}+ \times R_{\_shunt}}{R_{\_iso\_b}+ + R_{\_shunt}}\left(\frac{V_{batt}}{V_{pt\_b1}} - 1\right)$$ avec $R_{\_shunt}$ la résistance de shunt, $V_{batt}$ la tension de ladite source électrique, et $V_{pt\_b1}$ la deuxième tension mesurée pour cette séquence nulle.

Avantageusement, les deux modes de réalisation décrits ci-dessus peuvent être combinés (avec mesures des tensions pour les deux séquences nulles). Dans ce cas, on détermine quatre résistances équivalentes d'isolement $R_{\_iso\_h}+$, $R_{\_iso\_h}-$, $R_{\_iso\_b}+$ et $R_{\_iso\_b}-$. L'obtention des quatre résistances équivalentes d'isolement permet une détection précise d'un éventuel défaut d'isolement.

Conformément à une mise en œuvre de l'invention, le procédé peut comporter une étape de comparaison des résistances équivalentes d'isolement déterminées à un seuil. Cette comparaison à un seuil permet de déterminer l'existence d'un défaut d'isolement du système électrique. De plus, cette comparaison permet une localisation d'un éventuel défaut d'isolement du système électrique. De préférence, toutes les résistances équivalentes d'isolement déterminées peuvent être comparées au même seuil, de manière à faciliter la détection et la localisation d'un éventuel défaut d'isolement.

Le seuil S de comparaison peut être déterminé par une formule du type $S = a \times V_{batt}$ avec a un coefficient de sécurité et $V_{batt}$ la tension de la source électrique. De préférence le coefficient de sécurité a peut valoir 1000 $\Omega/V$, en effet cette valeur est prévue généralement dans les normes de sûreté des systèmes électriques.

Pour le mode de réalisation pour lequel on détermine les quatre résistances équivalentes d'isolement décrites ci-dessus, et on localise un éventuel défaut d'isolement au moyen des conditions suivantes :

i) si toutes les résistances équivalentes sont supérieures au seuil, alors il n'y a pas de défaut d'isolement du système électrique,

ii) si seulement les résistances équivalentes $R_{\_iso\_h}+$ et $R_{\_iso\_b}-$ sont inférieures au seuil, alors le défaut d'isolement est situé du côté de la charge électrique,

iii) si seulement les résistances équivalentes $R_{\_iso\_h}+$ et $R_{\_iso\_b}+$ sont inférieures au seuil, alors le défaut d'isolement est situé du côté de la borne positive de la source électrique,

iv) si seulement les résistances équivalentes $R_{\_iso\_h}-$ et $R_{\_iso\_b}-$ sont inférieures au seuil, alors le défaut d'isolement est situé du côté de la borne négative de la source électrique,

v) si seulement les résistances équivalentes $R_{\_iso\_h}+$, $R_{\_iso\_b}+$ et $R_{\_iso\_b}-$ sont inférieures au seuil, alors des défauts d'isolement sont situés du côté de la borne positive de la source électrique et du côté de la charge électrique,

vi) si seulement les résistances équivalentes $R_{\_iso\_h}+$, $R_{\_iso\_h}-$ et $R_{\_iso\_b}-$ sont inférieures au seuil, alors des défauts d'isolement sont situés du côté de la borne négative de la source électrique et du côté de la charge électrique, et vii) si toutes les résistances équivalentes sont inférieures au seuil, alors des défauts d'isolement sont situés du côté des bornes positives et négatives de la source électrique.

Ainsi, le procédé selon l'invention permet une localisation précise d'un défaut d'isolement, ce qui permet d'améliorer la sureté, et ce qui permet de remplacer uniquement les éléments défectueux sans avoir à remplacer l'ensemble du circuit électrique.

En outre, l'invention concerne un système de commande d'un système électrique, le système de commande étant configuré pour déterminer au moins deux résistances équivalentes d'isolement du système électrique, et de préférence quatre résistances équivalentes d'isolement.

Le système électrique selon l'invention intègre une source électrique, un convertisseur d'énergie (par exemple un onduleur) et une charge électrique.

La source électrique permet de fournir de l'énergie électrique, il peut s'agir d'une batterie électrique.

Le convertisseur d'énergie permet une conversion de l'énergie électrique. Par exemple, un convertisseur d'énergie peut permettre de convertir une tension alternative en une autre tension alternative avec une fréquence et/ou une amplitude différente, on parle alors de convertisseur alternatif/alternatif ou AC/AC. Selon un autre exemple, un convertisseur d'énergie peut permettre de convertir une tension alternative en une tension continue, on parle alors de redresseur, convertisseur alternatif/continu ou AC/DC. Pour la conversion inverse continu/alternatif, on parle d'onduleur ou convertisseur DC/AC. Selon un dernier exemple, un convertisseur d'énergie peut convertir une tension continue en une tension continue de tension différente, on parle alors de convertisseur DC/DC. Les convertisseurs peuvent être réversibles ou non réversibles. Généralement, la conversion est mise en œuvre au moyen de commutateurs (interrupteurs) commandés répartis sur plusieurs (généralement un nombre multiple de trois) branches de commutation. Chaque branche de commutation comporte deux interrupteurs commandés de manière opposée : lorsque le premier interrupteur commandé est ouvert, le second interrupteur commandé de la même branche est fermé et inversement.

La charge électrique désigne tout système utilisant de l'énergie électrique. La charge électrique peut être une machine électrique, une charge résistive, un réseau électrique, etc....

Selon un mode de réalisation préféré de l'invention, le système électrique comprend une batterie, un onduleur à trois branches DC/AC, et une machine électrique triphasée.

En outre, le système électrique intègre un circuit de mesure. Le circuit de mesure est utilisé et piloté pour déterminer les résistances équivalents d'isolement. En d'autres termes le circuit de mesure est inclus dans le système électrique. Ainsi, la détermination des résistances d'isolement peut être mise en œuvre sans équipement spécifique extérieur au système électrique.

Le circuit de mesure est ajouté entre la borne positive de la source électrique et la terre ou le châssis du système électrique.

Le circuit de mesure comporte une résistance de shunt en série avec un interrupteur commandé. La résistance de shunt peut avoir une valeur comprise entre 500k $\Omega$ et 5M$\Omega$.

Selon l'invention, le système de commande est configuré pour mettre en œuvre le procédé de détermination selon l'une quelconque des combinaisons de variantes décrites ci-dessus.

En particulier, le système de commande contrôle l'interrupteur commandé du circuit de mesure, et réalise les mesures de tension aux bornes du circuit de mesure. Le système de commande de réalise pas de commande spécifique des interrupteurs commandés de l'onduleur pour réaliser la détermination des résistances équivalentes d'isolement (la commande des interrupteurs commandés de l'onduleur est inchangée, par exemple au moyen d'une méthode de modulation de largeur d'impulsion).

L'invention concerne également l'utilisation d'un tel procédé et d'un tel système de commande pour un groupe moto propulseur électrique d'un véhicule, en particulier d'un véhicule électrique ou hybride.

Toutefois, le procédé et le système de commande selon l'invention sont adaptés à toutes applications embarquées ou stationnaires.

**Revendications**

1. Procédé de détermination d'au moins deux résistances équivalentes d'isolement d'un système électrique (1) intégrant une source électrique (2), un convertisseur d'énergie (11), et une charge électrique (3), ledit convertisseur d'énergie (11) comprenant une pluralité de branches de commutation, chacune desdites branches de commutation comprenant deux interrupteurs commandés (I1, I2, I3, I4, I5, I6), ledit système électrique intégrant en outre un circuit de mesure (5) ajouté entre la borne positive de ladite source électrique (2) et la terre ou le châssis (4) dudit système électrique (1), ledit circuit de mesure (5) comprenant une résistance de shunt (Rshunt) en série avec un interrupteur commandé (6), **caractérisé en ce que** l'on met en œuvre les étapes suivantes :

a) lorsque les interrupteurs commandés (I1, I2, I3, I4, I5, I6) dudit convertisseur d'énergie (11) sont en séquence nulle, on mesure deux tensions en parallèle dudit circuit de mesure (5), la première tension $V_{pt\_0}$ étant mesurée avec ledit interrupteur commandé (6) dudit circuit de mesure (5) en position ouverte, et la deuxième tension $V_{pt\_1}$ étant mesurée avec ledit interrupteur commandé (6) dudit circuit de mesure (5) en position fermée ; et

b) on détermine lesdites résistances équivalentes d'isolement dudit système électrique (1) au moyen desdites tensions mesurées $V_{pt\_0}$ et $V_{pt\_1}$.

2. Procédé selon la revendication 1, dans lequel on commande lesdits interrupteurs commandés (I1, I2, I3, I4, I5, I6) dudit convertisseur d'énergie (11) par une méthode de modulation de largeur d'impulsion.

3. Procédé selon l'une des revendications précédentes, dans lequel on détermine quatre résistances équivalentes d'isolement, en réitérant les étapes a) et b) pour chaque séquence nulle de la commande des interrupteurs commandés (I1, I2, I3, I4, I5, I6) dudit convertisseur d'énergie (11).

4. Procédé selon l'une des revendications précédentes, dans lequel on détermine une résistance équivalente d'isolement $R_{\_iso\_h}+$ entre la borne positive de ladite source électrique (2) et le châssis ou la terre (4) dudit système électrique (1) pour la séquence nulle pour laquelle les interrupteurs commandés (I1, I2, I3, I4, I5, I6) dudit convertisseur d'énergie (11) connectés à la borne positive de ladite source électrique (2) sont en position fermée par une équation du type :
$$R_{\_iso\_h}+ = R_{\_shunt}\left[\frac{V_{pt\_h0}}{V_{batt}-V_{pt\_h0}}\frac{V_{batt}-V_{pt\_h1}}{V_{pt\_h1}} - 1\right]$$
avec $R_{\_shunt}$ la résistance de shunt, $V_{batt}$ la tension de ladite source électrique (2), $V_{pt\_h0}$ la première tension mesurée pour cette séquence nulle et $V_{pt\_h1}$ la deuxième tension mesurée pour cette séquence nulle.

5. Procédé selon la revendication 4, dans lequel on détermine une résistance équivalente d'isolement $R_{\_iso\_h}-$ entre la borne négative de ladite source électrique (2) et le châssis ou la terre (4) dudit système électrique (1) pour la séquence nulle pour laquelle les interrupteurs commandés (I1, I2, I3, I4, I5, I6) dudit convertisseur d'énergie (11) connectés à la borne positive de ladite source électrique (2) sont en position fermée par une équation du type :
$$R_{\_iso\_h}- = \frac{R_{\_iso\_h}+ \times R_{\_shunt}}{R_{\_iso\_h}+ + R_{\_shunt}}\left(\frac{V_{batt}}{V_{pt\_h1}} - 1\right)$$
avec $R_{\_shunt}$ la résistance de shunt, $V_{batt}$ la tension de ladite source électrique (2), et $V_{pt\_h1}$ la deuxième tension mesurée pour cette séquence nulle.

6. Procédé selon l'une des revendications précédentes, dans lequel on détermine une résistance équivalente d'isolement $R_{\_iso\_b}+$ entre la borne positive de ladite source électrique (2) et le châssis ou la terre (4) dudit système électrique pour la séquence nulle pour laquelle les interrupteurs commandés (I1, I2, I3, I4, I5, I6) dudit convertisseur d'énergie (11) connectés à la borne négative de ladite source électrique (2) sont en position fermée par une équation du type :
$$R_{\_iso\_b}+ = R_{\_shunt}\left[\frac{V_{pt\_b0}}{V_{batt}-V_{pt\_b0}}\frac{V_{batt}-V_{pt\_b1}}{V_{pt\_b1}} - 1\right]$$
avec $R_{\_shunt}$ la résistance de shunt, $V_{batt}$ la tension de ladite source électrique (2), $V_{pt\_b0}$ la première tension mesurée pour cette séquence nulle et $V_{pt\_b1}$ la deuxième tension mesurée pour cette séquence nulle.

7. Procédé selon la revendication 6, dans lequel on détermine une résistance équivalente d'isolement $R_{\_iso\_b}-$ entre la borne négative de ladite source électrique (2) et le châssis ou la terre (4) dudit système électrique (1) pour la séquence nulle pour laquelle les interrupteurs commandés (I1, I2, I3, I4, I5, I6) dudit onduleur connectés à la borne négative de ladite source électrique (2) sont en position fermée par une équation du type :
$$R_{\_iso\_b}- = \frac{R_{\_iso\_b}+ \times R_{\_shunt}}{R_{\_iso\_b}+ + R_{\_shunt}}\left(\frac{V_{batt}}{V_{pt\_b1}} - 1\right)$$
avec $R_{\_shunt}$ la résistance de shunt, $V_{batt}$ la tension de ladite source électrique (2), et $V_{pt\_b1}$ la deuxième tension mesurée pour cette séquence nulle.

8. Procédé selon l'une des revendications précédentes, dans lequel on compare lesdites résistances équivalentes d'isolement à un seuil pour déterminer un éventuel défaut d'isolement dudit système électrique.

9. Procédé selon les revendication 3 et 8, dans lequel on localise le défaut éventuel d'isolement en mettant en œuvre les conditions suivantes :

> i) si toutes les résistances équivalentes sont supérieures audit seuil, alors il n'y a pas de défaut d'isolement dudit système électrique,
> ii) si seulement les résistances équivalentes $R_{iso\_h}+$ et $R_{iso\_b}-$ sont inférieures audit seuil, alors le défaut d'isolement est situé du côté de ladite charge électrique (3),
> iii) si seulement les résistances équivalentes $R_{iso\_h}+$ et $R_{iso\_b}+$ sont inférieures audit seuil, alors le défaut d'isolement est situé du côté de la borne positive de ladite source électrique (2),
> iv) si seulement les résistances équivalentes $R_{iso\_h}-$ et $R_{iso\_b}-$ sont inférieures audit seuil, alors le défaut d'isolement est situé du côté de la borne négative de ladite source électrique (2),
> v) si seulement les résistances équivalentes $R_{iso\_h}+$, $R_{iso\_b}+$ et $R_{iso\_b}-$ sont inférieures audit seuil, alors des défauts d'isolement sont situés du côté de la borne positive de ladite source électrique (2) et du côté de ladite charge électrique (3),
> vi) si seulement les résistances équivalentes $R_{iso\_h}+$, $R_{iso\_h}-$ et $R_{iso\_b}-$ sont inférieures audit seuil, alors des défauts d'isolement sont situés du côté de la borne négative de ladite source électrique (2) et du côté de ladite charge électrique (3), et
> vii) si toutes les résistances équivalentes sont inférieures audit seuil, alors des défauts d'isolement sont situés du côté des bornes positives et négatives de ladite source électrique (2).

10. Procédé selon l'une des revendications 8 ou 9, dans lequel ledit seuil S est déterminé par une formule du type $S = a \times V_{batt}$ avec $a$ un coefficient de sécurité et $V_{batt}$ la tension de ladite source électrique (2), de préférence le coefficient de sécurité $a$ vaut 1000 $\Omega/V$.

11. Système de commande d'un système électrique (1) pour la détermination d'au moins deux résistances équivalentes d'isolement dudit système électrique (1), ledit système électrique (1) intégrant une source électrique (2), un convertisseur d'énergie (11), une charge électrique (3) et un circuit de mesure (5), ledit onduleur comprenant une pluralité de branches de commutation, chacune desdites branches de commutation comprenant deux interrupteurs commandés (I1, I2, I3, I4, I5, I6), ledit circuit de mesure (5) comprenant une résistance de shunt (Rshunt) en série avec un interrupteur commandé (6) ajoutés entre la borne positive de ladite source électrique (2) et la terre ou le châssis (4) dudit système électrique (1), **caractérisé en ce que** ledit système de commande est configuré pour mettre en œuvre le procédé selon l'une des revendications précédentes.

12. Système de commande selon la revendication 11, dans lequel ladite charge électrique (3) est une machine électrique, et ladite source électrique (2) est une batterie électrique.

13. Utilisation d'un système de commande selon la revendication 12 pour la commande d'un groupe motopropulseur d'un véhicule électrique ou hybride.

**Patentansprüche**

1. Verfahren zur Bestimmung mindestens zweier äquivalenter Isolationswiderstände eines elektrischen Systems (1), das eine Stromquelle (2), einen Energieumrichter (11) und eine elektrische Last (3) beinhaltet, wobei der Energieumrichter (11) eine Vielzahl von Schaltzweigen enthält, wobei jeder der Schaltzweige zwei gesteuerte Schalter (I1, I2, I3, I4, I5, I6) enthält, wobei das elektrische System außerdem einen Messkreis (5) beinhaltet, der zwischen dem positiven Pol der Stromquelle (2) und der Erde oder dem Gestell (4) des elektrischen Systems (1) hinzugefügt ist, wobei der Messkreis (5) einen Shunt-Widerstand (Rshunt) in Reihe mit einem gesteuerten Schalter (6) enthält, **dadurch gekennzeichnet, dass** die folgenden Schritte durchgeführt werden:

> a) wenn die gesteuerten Schalter (I1, I2, I3, I4, I5, I6) des Energieumrichters (11) in Nullfolge sind, werden zwei Spannungen des Messkreises (5) parallel gemessen, wobei die erste Spannung $V_{pt\_0}$ mit dem gesteuerten Schalter (6) des Messkreises (5) in offener Stellung gemessen wird, und die zweite Spannung $V_{pt\_1}$ mit dem gesteuerten Schalter (6) des Messkreises (5) in geschlossener Stellung gemessen wird; und
> b) die äquivalenten Isolationswiderstände des elektrischen Systems (1) werden mittels der gemessenen Spannungen $V_{pt\_0}$ und $V_{pt\_1}$ bestimmt.

2. Verfahren nach Anspruch 1, wobei die gesteuerten Schalter (I1, I2, I3, I4, I5, I6) des Energieumrichters (11) durch eine Impulsbreitenmodulationsmethode gesteuert werden.

3. Verfahren nach einem der vorhergehenden Ansprüche, wobei vier äquivalente Isolationswiderstände bestimmt werden, indem die Schritte a) und b) für jede Nullfolge der Steuerung der gesteuerten Schalter (I1, I2, I3, I4, I5, I6) des Energieumrichters (11) wiederholt werden.

4. Verfahren nach einem der vorhergehenden Ansprüche, wobei ein äquivalenter Isolationswiderstand $R_{iso\_h}^{+}$ zwischen dem positiven Pol der Stromquelle (2) und dem Gestell oder der Erde (4) des elektrischen Systems (1) für die Nullfolge, für die die gesteuerten Schalter (I1, I2, I3, I4, I5, I6) des Energieumrichters (11), die mit dem positiven Pol der Stromquelle (2) verbunden sind, in geschlossener Stellung sind, durch eine Gleichung des Typs:

$$R_{\_iso\_h^+} = R_{\_shunt}\left[\frac{V_{pt\_h0}}{V_{batt} - V_{pt\_h0}}\frac{V_{batt} - V_{pt\_h1}}{V_{pt\_h1}} - 1\right]$$

bestimmt wird, mit $R_{\_shunt}$ dem Shunt-Widerstand, $V_{batt}$ der Spannung der Stromquelle (2), $V_{pt\_h0}$ der ersten für diese Nullfolge gemessenen Spannung und $V_{pt\_h1}$ der zweiten für diese Nullfolge gemessenen Spannung.

5. Verfahren nach Anspruch 4, wobei ein äquivalenter Isolationswiderstand $R_{iso\_h}^{-}$ zwischen dem negativen Pol der Stromquelle (2) und dem Gestell oder der Erde (4) des elektrischen Systems (1) für die Nullfolge, für die die gesteuerten Schalter (I1, I2, I3, I4, I5, I6) des Energieumrichters (11), die mit dem positiven Pol der Stromquelle (2) verbunden sind, in geschlossener Stellung sind, durch eine Gleichung des Typs:

$$R_{\_iso\_h^-} = \frac{R_{\_iso\_h^+} \times R_{\_shunt}}{R_{\_iso\_h^+} + R_{\_shunt}}\left(\frac{V_{batt}}{V_{pt\_h1}} - 1\right)$$

bestimmt wird, mit $R_{\_shunt}$ dem Shunt-Widerstand, $V_{batt}$ der Spannung der Stromquelle (2), und $V_{pt\_h1}$ der zweiten für diese Nullfolge gemessenen Spannung.

6. Verfahren nach einem der vorhergehenden Ansprüche, wobei ein äquivalenter Isolationswiderstand $R_{\_iso\_b}^{+}$ zwischen dem positiven Pol der Stromquelle (2) und dem Gestell oder der Erde (4) des elektrischen Systems für die Nullfolge, für die die gesteuerten Schalter (I1, I2, I3, I4, I5, I6) des Energieumrichters (11), die mit dem negativen Pol der Stromquelle (2) verbunden sind, durch eine Gleichung des Typs:

$$R_{\_iso\_b^+} = R_{\_shunt}\left[\frac{V_{pt\_b0}}{V_{batt} - V_{pt\_b0}}\frac{V_{batt} - V_{pt\_b1}}{V_{pt\_b1}} - 1\right]$$

bestimmt wird, mit $R_{\_shunt}$ dem Shunt-Widerstand, $V_{batt}$ der Spannung der Stromquelle (2), $V_{pt\_b0}$ der ersten für diese Nullfolge gemessenen Spannung und $V_{pt\_b1}$ der zweiten für diese Nullfolge gemessenen Spannung.

7. Verfahren nach Anspruch 6, wobei ein äquivalenter Isolationswiderstand $R_{iso\_b}^{-}$ zwischen dem negativen Pol der Stromquelle (2) und dem Gestell oder der Erde (4) des elektrischen Systems (1) für die Nullfolge, für die die gesteuerten Schalter (I1, I2, I3, I4, I5, I6) des Energieumrichter, die mit dem negativen Pol der Stromquelle (2) verbunden sind, durch eine Gleichung des Typs:

$$R_{\_iso\_b^-} = \frac{R_{\_iso\_b^+} \times R_{\_shunt}}{R_{\_iso\_b^+} + R_{\_shunt}}\left(\frac{V_{batt}}{V_{pt\_b1}} - 1\right)$$

bestimmt wird, mit $R_{\_shunt}$ dem Shunt-Widerstand, $V_{batt}$ der Spannung der Stromquelle (2), und $V_{pt\_b1}$ der zweiten für diese Nullfolge gemessenen Spannung.

8. Verfahren nach einem der vorhergehenden Ansprüche, wobei die äquivalenten Isolationswiderstände mit einer Schwelle verglichen werden, um einen möglichen Isolationsfehler des elektrischen Systems zu bestimmen.

9. Verfahren nach den Ansprüchen 3 und 8, wobei der mögliche Isolationsfehler lokalisiert wird, indem die folgenden Bedingungen angewendet werden:

i) wenn alle äquivalenten Widerstände höher sind als die Schwelle, gibt es keinen Isolationsfehler des elektrischen Systems,

ii) wenn nur die äquivalenten Widerstände $R_{iso\_h}^+$ und $R_{iso\_b}^-$ niedriger sind als die Schwelle, befindet sich der Isolationsfehler auf der Seite der elektrischen Last (3),

iii) wenn nur die äquivalenten Widerstände $R_{iso\_h}^+$ und $R_{iso\_b}^+$ niedriger sind als die Schwelle, befindet sich der Isolationsfehler auf der Seite des positiven Pols der Stromquelle (2),

iv) wenn nur die äquivalenten Widerstände $R_{iso\_h}^-$ und $R_{iso\_b}^-$ niedriger sind als die Schwelle, befindet sich der Isolationsfehler auf der Seite des negativen Pols der Stromquelle (2),

v) wenn nur die äquivalenten Widerstände $R_{iso\_h}^+$, $R_{iso\_b}^+$ und $R_{iso\_b}^-$ niedriger sind als die Schwelle, befinden sich Isolationsfehler auf der Seite des positiven Pols der Stromquelle (2) und auf der Seite der elektrischen Last (3),

vi) wenn nur die äquivalenten Widerstände $R_{iso\_h}^+$, $R_{iso\_h}^-$ und $R_{iso\_b}^-$ niedriger sind als die Schwelle, befinden sich Isolationsfehler auf der Seite des negativen Pols der Stromquelle (2) und auf der Seite der elektrischen Last (3), und

vii) wenn alle äquivalenten Widerstände niedriger sind als die Schwelle, befinden sich Isolationsfehler auf der Seite der positiven und negativen Pole der Stromquelle (2).

10. Verfahren nach einem der Ansprüche 8 oder 9, wobei die Schwelle S durch eine Formel des Typs $S = \alpha \times V_{batt}$ bestimmt wird, mit $\alpha$ einem Sicherheitskoeffizienten und $V_{batt}$ der Spannung der Stromquelle (2), vorzugsweise hat der Sicherheitskoeffizient $\alpha$ den Wert 1000 Ω/V.

11. Steuersystem eines elektrischen Systems (1) zur Bestimmung von mindestens zwei äquivalenten Isolationswiderständen des elektrischen Systems (1), wobei das elektrische System (1) eine Stromquelle (2), einen Energieumrichter (11), eine elektrische Last (3) und einen Messkreis (5) beinhaltet, wobei der Wechselrichter eine Vielzahl von Schaltzweigen enthält, wobei jeder der Schaltzweige zwei gesteuerte Schalter (I1, I2, I3, I4, I5, I6) enthält, wobei der Messkreis (5) einen Shunt-Widerstand (Rshunt) in Reihe mit einem gesteuerten Schalter (6) enthält, die zwischen dem positiven Pol der Stromquelle (2) und der Erde oder dem Gestell (4) des elektrischen Systems (1) hinzugefügt sind, **dadurch gekennzeichnet, dass** das Steuersystem konfiguriert ist, das Verfahren nach einem der vorhergehenden Ansprüche durchzuführen.

12. Steuersystem nach Anspruch 11, wobei die elektrische Last (3) eine elektrische Maschine und die Stromquelle (2) eine elektrische Batterie ist.

13. Verwendung eines Steuersystems nach Anspruch 12 zur Steuerung einer Antriebseinheit eines Elektro- oder Hybridfahrzeugs.

**Claims**

1. Method for determining at least two equivalent insulation resistances of an electrical system (1) incorporating an electrical source (2), a power converter (11), and an electrical load (3), said power converter (11) comprising a plurality of switching branches, each of said switching branches comprising two controlled switches (I1, I2, I3, I4, I5, I6), said electrical system further incorporating a measuring circuit (5) added between the positive terminal of said electrical source (2) and the ground or the frame (4) of said electrical system (1), said measuring circuit (5) comprising a shunt resistor (Rshunt) in series with a controlled switch (6), **characterized in that** the following steps are implemented:

a) when the controlled switches (I1, I2, I3, I4, I5, I6) of said power converter (11) are in a zero sequence, two voltages are measured in parallel with said measuring circuit (5), the first voltage $V_{pt\_0}$ being measured with said controlled switch (6) of said measuring circuit (5) in the open position, and the second voltage $V_{pt\_1}$ being measured with said controlled switch (6) of said measuring circuit (5) in the closed position; and

b) said equivalent insulation resistances of said electrical system (1) are determined by means of said measured voltages $V_{pt\_0}$ and $V_{pt\_1}$.

2. Method according to Claim 1, wherein said controlled switches (I1, I2, I3, I4, I5, I6) of said power converter (11) are controlled using a pulse-width modulation method.

3. Method according to either of the preceding claims, wherein four equivalent insulation resistances are determined, by reiterating steps a) and b) for each zero sequence of the control of the controlled switches (I1, I2, I3, I4, I5, I6) of said power converter (11).

4. Method according to one of the preceding claims, wherein an equivalent insulation resistance $R_{\_iso\_h}+$ between the positive terminal of said electrical source (2) and the frame or the ground (4) of said electrical system (1) is determined for the zero sequence for which the controlled switches (I1, I2, I3, I4, I5, I6) of said power converter (11) which are connected to the positive terminal of said electrical source (2) are in the closed position using an equation of the type: $R_{\_iso\_h}+ = R_{\_shunt} \left[ \dfrac{V_{pt\_h0}}{V_{batt} - V_{pt\_h0}} \dfrac{V_{batt} - V_{pt\_h1}}{V_{pt\_h1}} - 1 \right]$ with $R_{\_shunt}$ being the shunt resistor, $V_{batt}$ the voltage of said electrical source (2), $V_{pt\_h0}$ the first voltage measured for this zero sequence and $V_{pt\_h1}$ the second voltage measured for this zero sequence.

5. Method according to Claim 4, wherein an equivalent insulation resistance $R_{\_iso\_h}-$ between the negative terminal of said electrical source (2) and the frame or the ground (4) of said electrical system (1) is determined for the zero sequence for which the controlled switches (I1, I2, I3, I4, I5, I6) of said power converter (11) which are connected to the positive terminal of said electrical source (2) are in the closed position using an equation of the type: $$R_{\_iso\_h}- = \frac{R_{\_iso\_h}+ \times R_{\_shunt}}{R_{\_iso\_h}+ + R_{\_shunt}} \left( \frac{V_{batt}}{V_{pt\_h1}} - 1 \right)$$ with $R_{\_shunt}$ being the shunt resistor, $V_{batt}$ the voltage of said electrical source (2), and $V_{pt\_h1}$ the second voltage measured for this zero sequence.

6. Method according to one of the preceding claims, wherein an equivalent insulation resistance $R_{\_iso\_b}+$ between the positive terminal of said electrical source (2) and the frame or the ground (4) of said electrical system is determined for the zero sequence for which the controlled switches (I1, I2, I3, I4, I5, I6) of said power converter (11) which are connected to the negative terminal of said electrical source (2) are in the closed position using an equation of the type: $R_{\_iso\_b}+ = R_{\_shunt} \left[ \dfrac{V_{pt\_b0}}{V_{batt} - V_{pt\_b0}} \dfrac{V_{batt} - V_{pt\_b1}}{V_{pt\_b1}} - 1 \right]$ with $R_{\_shunt}$ being the shunt resistor, $V_{batt}$ the voltage of said electrical source (2), $V_{pt\_b0}$ the first voltage measured for this zero sequence and $V_{pt\_b1}$ the second voltage measured for this zero sequence.

7. Method according to Claim 6, wherein an equivalent insulation resistance $R_{\_iso\_b}-$ between the negative terminal of said electrical source (2) and the frame or the ground (4) of said electrical system (1) is determined for the zero sequence for which the controlled switches (I1, I2, I3, I4, I5, I6) of said power converter which are connected to the negative terminal of said electrical source (2) are in the closed position using an equation of the type: $$R_{\_iso\_b}- = \frac{R_{\_iso\_b}+ \times R_{\_shunt}}{R_{\_iso\_b}+ + R_{\_shunt}} \left( \frac{V_{batt}}{V_{pt\_b1}} - 1 \right)$$ with $R_{\_shunt}$ being the shunt resistor, $V_{batt}$ the voltage of said electrical source (2), and $V_{pt\_b1}$ the second voltage measured for this zero sequence.

8. Method according to one of the preceding claims, wherein said equivalent insulation resistances are compared with a threshold so as to identify a possible insulation fault of said electrical system.

9. Method according to Claims 3 and 8, wherein the possible insulation fault is located by implementing the following conditions:

   i) if all the equivalent resistances are above said threshold, then there is no insulation fault of said electrical system,
   ii) if only the equivalent resistances $R_{\_iso\_h}+$ and $R_{\_iso\_b}-$ are below said threshold, then the insulation fault is located in the vicinity of said electrical load (3),
   iii) if only the equivalent resistances $R_{\_iso\_h}+$ and $R_{\_iso\_b}+$ are below said threshold, then the insulation fault is located in the vicinity of the positive terminal of said electrical source (2),

iv) if only the equivalent resistances $R_{\_iso\_h}$- and $R_{\_iso\_b}$- are below said threshold, then the insulation fault is located in the vicinity of the negative terminal of said electrical source (2),

v) if only the equivalent resistances $R_{\_iso\_h}$+, $R_{\_iso\_b}$+ and $R_{\_iso\_b}$- are below said threshold, then insulation faults are located in the vicinity of the positive terminal of said electrical source (2) and in the vicinity of said electrical load (3),

vi) if only the equivalent resistances $R_{\_iso\_h}$+, $R_{\_iso\_h}$- and $R_{\_iso\_b}$- are below said threshold, then insulation faults are located in the vicinity of the negative terminal of said electrical source (2) and in the vicinity of said electrical load (3), and

vii) if all the equivalent resistances are below said threshold, then insulation faults are located in the vicinity of the positive and negative terminals of said electrical source (2) .

10. Method according to either of Claims 8 and 9, wherein said threshold S is determined using a formula of the type $S = a \times V_{batt}$ with $a$; being a safety coefficient and $V_{batt}$ the voltage of said electrical source (2), the safety coefficient $a$ preferably being equal to 1000 $\Omega$/V.

11. Control system for an electrical system (1) for determining at least two equivalent insulation resistances of said electrical system (1), said electrical system (1) incorporating an electrical source (2), a power converter (11), an electrical load (3) and a measuring circuit (5), said inverter comprising a plurality of switching branches, each of said switching branches comprising two controlled switches (I1, I2, I3, I4, I5, I6), said measuring circuit (5) comprising a shunt resistor (Rshunt) in series with a controlled switch (6) which are added between the positive terminal of said electrical source (2) and the ground or the frame (4) of said electrical system (1), **characterized in that** said control system is configured to implement the method according to one of the preceding claims.

12. Control system according to Claim 11, wherein said electrical load (3) is an electric machine, and said electrical source (2) is an electric battery.

13. Use of a control system according to Claim 12 for the control of a powertrain of an electric or hybrid vehicle.

Figure 1

k1, k2, k3

Figure 2

## RÉFÉRENCES CITÉES DANS LA DESCRIPTION

**Documents brevets cités dans la description**

- EP 2413148 A
- US 20030234653 A
- US 2015042350 A
- US 7554336 B
- US 2012223734 A
- WO 2013124571 A
- US 20110320146 A